# FASCICULE DE BREVET EUROPEEN

(11) **EP 3 503 295 B1**
(45) Date de publication et mention de la délivrance du brevet: **26.06.2024**
(21) Numéro de dépôt: 18214875.9
(22) Date de dépôt: 20.12.2018
(51) Int. Cl.: H01Q 1/38, H01Q 1/32, H01Q 1/22, H01Q 7/08, H05K 1/14, H05K 3/36, H05K 1/11

(54) **BOITIER ANTENNE POUR VEHICULE AUTOMOBILE**
ANTENNENGEHÄUSE FÜR KRAFTFAHRZEUG
ANTENNA UNIT FOR A MOTOR VEHICLE

(30) Priorité: 20.12.2017 FR 1762686; 20.12.2017 FR 1762685
(43) Date de publication de la demande: 26.06.2019
(73) Titulaire: Valeo Comfort and Driving Assistance, 94000 Créteil (FR)
(72) Inventeur: DESCHAMPS, Maxime, 94000 Créteil CEDEX (FR); BONIFACE, Sébastien, 94000 Créteil CEDEX (FR); COLOMBE, Sébastien, 94000 Créteil CEDEX (FR)
(74) Mandataire: Delaval, Guillaume Laurent

(56) Documents cités:
- EP-A1- 2 790 329
- EP-A1- 2 937 821
- US-A- 5 323 898
- US-A1- 2007 206 365
- US-A1- 2009 173 795

## Description

La présente invention concerne un boîtier antenne pour véhicule automobile. Elle trouve une application particulière mais non limitative dans le domaine des véhicules automobiles.

Dans le domaine des véhicules automobiles, un boîtier antenne pour véhicule automobile, connu de l'homme du métier, est un boîtier antenne NFC (« Near Field Communication » en anglais) fermé qui comprend une ouverture dans laquelle une carte électronique et une antenne sont disposées dans ledit boîtier et entourée de résine. L'antenne est déportée de ladite carte électronique et est en contact électrique avec ladite carte électronique au moyen d'une patte ressort en contact avec une zone métallisée de ladite antenne, formant ainsi un point de contact électrique. La résine est coulée dans ladite ouverture puis polymérisée. Le boîtier antenne est placé au niveau du montant de portière du véhicule automobile.

Un inconvénient de cet état de la technique antérieur est que par temps chaud, le montant de portière représente une zone de chaleur du fait de la carrosserie du véhicule automobile qui chauffe, ce qui entraine un réchauffement de la résine coulée dans le boîtier antenne. Lorsque la résine chauffe, la résine qui se trouve entre l'antenne et la carte électronique se dilate ce qui entraîne l'apparition d'un jeu au niveau du point de contact électrique entre ladite antenne et ladite carte électronique. En conséquence, il y a une perte de contact électrique entre ladite antenne et ladite carte électronique et l'antenne ne fonctionne plus.

Dans ce contexte, la présente invention vise à proposer un boîtier antenne pour véhicule automobile qui permet de résoudre l'inconvénient mentionné.

La publication de demande de brevet US2009173795A1 divulgue un dispositif d'information de type carte comprend une carte de câblage ayant un motif de câblage avec un composant électronique monté sur une première face de la carte de câblage et une électrode de connexion d'antenne, une carte d'antenne ayant un motif d'antenne avec des électrodes de borne d'antenne formées sur une première face de la carte d'antenne, un matériau magnétique placé entre la carte de câblage et la carte d'antenne se faisant face, une carte de câblage flexible pour coupler l'électrode de connexion d'antenne à l'électrode de borne d'antenne, et un logement pour loger la carte de câblage, la carte d'antenne, le matériau magnétique et la carte de câblage flexible. La carte de câblage et la carte d'antenne sont réalisées à partir d'une seule et même carte mère isolante.

### DESCRIPTION GENERALE DE L'INVENTION

A cette fin l'invention propose un boîtier antenne pour véhicule automobile, selon la revendication 1.

Selon un mode de réalisation non limitatif, ledit réceptacle comprend en outre au moins un plot de positionnement de ladite platine support primaire et de ladite platine support secondaire dans ledit réceptacle.

Selon un mode de réalisation non limitatif, ledit réceptacle comprend trois plots de positionnement.

Selon un mode de réalisation non limitatif, ledit au moins plot de positionnement comprend une base sur laquelle peut reposer ladite platine support secondaire, ladite base étant configurée de sorte à avoir un espace entre ladite platine support primaire et ladite platine support secondaire.

Selon un mode de réalisation non limitatif, ladite base comprend une hauteur sensiblement comprise entre 1 mm et 3mm.

Selon un mode de réalisation non limitatif, ladite platine support primaire comprend des pistes sérigraphiées et une ferrite adaptée pour être disposée en regard de ladite platine support secondaire.

Selon un mode de réalisation non limitatif, ladite platine support primaire est une carte électronique flexible ou une carte à circuit imprimé.

Selon un mode de réalisation non limitatif, ladite antenne est une antenne en champ proche.

Selon un mode de réalisation non limitatif, ladite platine support secondaire est une carte à circuit imprimé.

Selon un mode de réalisation non limitatif, ladite platine support primaire comprend en outre une surface primaire plane.

Selon un mode de réalisation non limitatif, ledit boîtier est en matériau plastique.

Selon un mode de réalisation non limitatif, lesdites zones métallisées sont planes.

Selon un mode de réalisation non limitatif,
a. ledit réceptacle comprend des broches métalliques,
b. lesdites zones métallisées sont adaptées pour coopérer avec lesdites broches métalliques dudit réceptacle, et
c. lesdits vias sont en outre adaptés pour coopérer avec lesdites broches métalliques dudit réceptacle.

Selon un mode de réalisation non limitatif, lesdites zones métallisées sont des trous métallisés à travers lesquels lesdites broches métalliques dudit réceptacle peuvent s'insérer.

Selon un mode de réalisation non limitatif, ledit réceptacle comprend deux broches métalliques.

L'invention et ses différentes applications seront mieux comprises à la lecture de la description qui suit et à l'examen des figures qui l'accompagnent :
la [Figure 1] représente une vue éclatée d'un boîtier antenne pour véhicule automobile selon un premier mode de réalisation non limitatif de l'invention, ledit boîtier comprenant un réceptacle, un couvercle, une platine support primaire et une platine support secondaire ;
la [Figure 2] représente une vue assemblée en perspective du boîtier antenne de la figure 1, selon un mode de réalisation non limitatif ;
la [Figure 3a] illustre une vue de dessus de la platine support secondaire du boîtier antenne des figures 1 et 2, selon un mode de réalisation non limitatif ;
la [Figure 3b] illustre une vue de la platine support primaire du boîtier antenne des figures 1 et 2 comprenant des pistes sérigraphiées, selon un mode de réalisation non limitatif ;
la [Figure 3c] illustre une vue de la platine support primaire de la figure 3b comprenant une ferrite, selon un mode de réalisation non limitatif ;
la [Figure 4] représente un zoom d'une partie du réceptacle du boîtier antenne des figures 1 et 2, illustrant un bossage dudit réceptacle ;
la [Figure 5] représente un zoom d'une partie du réceptacle de la figure 4, sur laquelle est disposée une partie de la platine support primaire dudit boîtier antenne, ladite partie comprenant des zones métallisées, selon un mode de réalisation non limitatif ;
la [Figure 6] représente une vue de dessus du réceptacle du boîtier antenne des figures 1 et 2, dans lequel est disposée la platine support primaire dudit boîtier antenne, selon un mode de réalisation non limitatif ;
la [Figure 7a] représente le réceptacle du boîtier antenne des figures 1 et 2 en perspective, dans lequel sont disposées la platine support primaire et la platine support secondaire dudit boîtier antenne, selon un mode de réalisation non limitatif ;
la [Figure 7b] représente le réceptacle de la figure 7a de profil, selon un mode de réalisation non limitatif ;
la [Figure 8] est un zoom sur une partie de la figure 7a illustrant des vias de ladite platine support secondaire, selon un mode de réalisation non limitatif ;
la [Figure 9] est un schéma illustrant une soudure de vias de la platine support secondaire de la figure 8 avec des zones métallisées de la platine support primaire de la figure 5, selon un mode de réalisation non limitatif ;
la [Figure 10] illustre un schéma d'un assemblage de la platine support primaire et de la platine support secondaire du boîtier antenne des figures 1 et 2, selon un premier mode de réalisation non limitatif ;
la [Figure 11] illustre un schéma d'un assemblage de la platine support primaire et de la platine support secondaire du boîtier antenne des figures 1 et 2, selon un deuxième mode de réalisation non limitatif ;
la [Figure 12] représente une vue éclatée d'un boîtier antenne pour véhicule automobile selon un deuxième mode de réalisation non limitatif de l'invention, ledit boîtier comprenant un réceptacle, un couvercle, une platine support primaire et une platine support secondaire ;
la [Figure 13] représente une vue assemblée en perspective du boîtier antenne de la figure 12, selon un mode de réalisation non limitatif ;
la [Figure 14a] illustre une vue de dessus de la platine support secondaire du boîtier antenne des figures 12 et 13, selon un mode de réalisation non limitatif ;
la [Figure 14b] illustre une vue de la platine support primaire du boîtier antenne des figures 12 et 13 comprenant des pistes sérigraphiées, selon un mode de réalisation non limitatif ;
la [Figure 14c] illustre une vue de la platine support primaire de la figure 14b comprenant une ferrite, selon un mode de réalisation non limitatif ;
la [Figure 15] représente un zoom d'une partie du réceptacle du boîtier antenne des figures 12 et 13, illustrant un bossage et des broches métalliques dudit réceptacle ;
la [Figure 16] représente un zoom d'une partie du réceptacle de la figure 15, sur laquelle est disposée une partie de la platine support primaire dudit boîtier antenne, ladite partie comprenant des zones métallisées, selon un mode de réalisation non limitatif ;
la [Figure 17] représente une vue de dessus du réceptacle du boîtier antenne des figures 12 et 13, dans lequel est disposée la platine support primaire dudit boîtier antenne, selon un mode de réalisation non limitatif ;
la [Figure 18a] représente le réceptacle du boîtier antenne des figures 12 et 13 en perspective, dans lequel sont disposées la platine support primaire et la platine support secondaire dudit boîtier antenne, selon un mode de réalisation non limitatif ;
la [Figure 18b] représente le réceptacle de la figure 18a de profil, selon un mode de réalisation non limitatif ;
la [Figure 19] est un zoom sur une partie de la figure 18a illustrant des vias de ladite platine support secondaire, selon un mode de réalisation non limitatif ;
la [Figure 20] est un schéma illustrant une soudure de vias de la platine support secondaire de la figure 19 avec des zones métallisées de la platine support primaire de la figure 16 et des broches métalliques du réceptacle de la figure 16, selon un mode de réalisation non limitatif ;
la [Figure 21] illustre un schéma d'un assemblage de la platine support primaire et de la platine support secondaire du boîtier antenne des figures 12 et 13, selon un premier mode de réalisation non limitatif ;
la [Figure 22] illustre un schéma d'un assemblage de la platine support primaire et de la platine support secondaire du boîtier antenne des figures 12 et 13, selon un deuxième mode de réalisation non limitatif ;
la [Figure 23] illustre un assemblage du boîtier antenne des figures 1 et 2, ou des figures 12 et 13 sur une carrosserie d'un véhicule automobile, selon un mode de réalisation non limitatif.

Les éléments identiques, par structure ou par fonction, apparaissant sur différentes figures conservent, sauf précision contraire, les mêmes références.

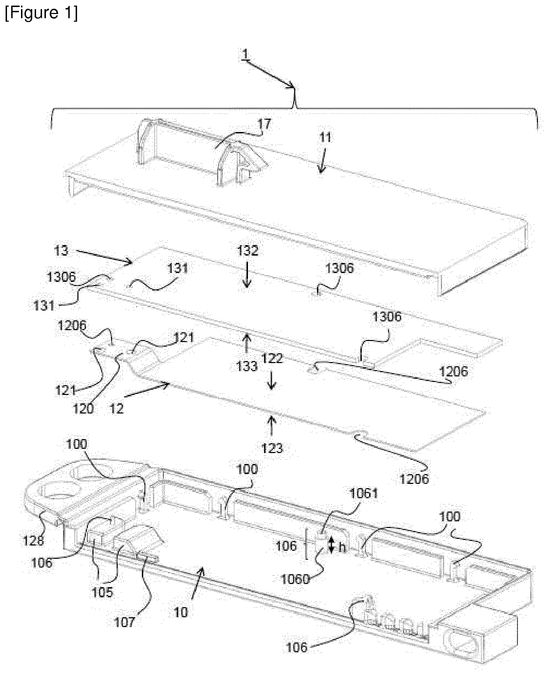

L'invention concerne un boîtier antenne 1 pour véhicule automobile 2. Ledit boîtier antenne 1 est décrit en référence aux figures 1 à 23.

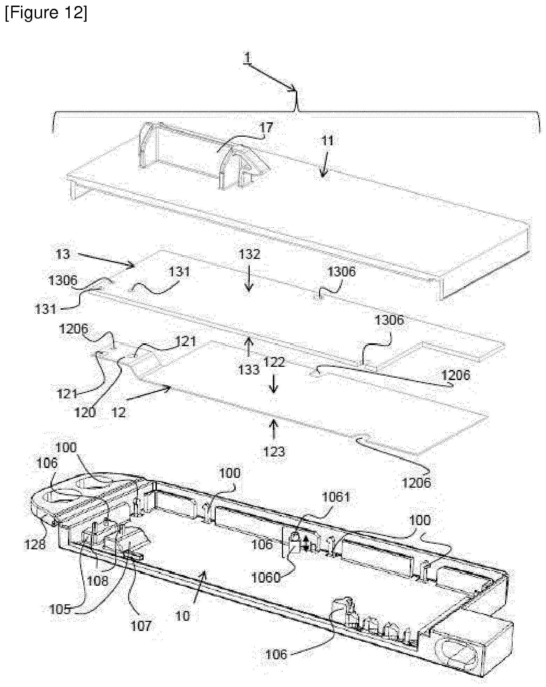

Tel qu'illustré sur les figures 1 et 12, le boîtier antenne 1 comprend :
a. un réceptacle 10 adapté pour accueillir une platine support primaire 12 et une platine support secondaire 13,
b. un couvercle 11 adapté pour fermer ledit boîtier antenne 1,
c. ladite platine support primaire 12 formant une antenne, et
d. ladite platine support secondaire 13 adaptée pour être disposée en regard de ladite platine support primaire 12 et comprenant des composants électroniques 130 adaptés pour coopérer avec ladite antenne 12.

Dans la description, la platine support primaire 12 est également appelée antenne 12. Ledit boîtier antenne 1 est en matériau plastique. Il permet de protéger l'antenne 12 et permet de la monter sur le véhicule automobile 2. Par ailleurs, le boîtier antenne 1 permet de laisser passer les ondes en champ proche. Il reste ainsi perméable aux champs magnétiques. Le boîtier antenne 1 étant en deux parties, le réceptacle 10 et le couvercle 11, il permet d'accéder à la platine support primaire 12 et à la platine support secondaire 13 pour effectuer un contact électrique entre les deux avant de refermer ledit boîtier antenne 1.

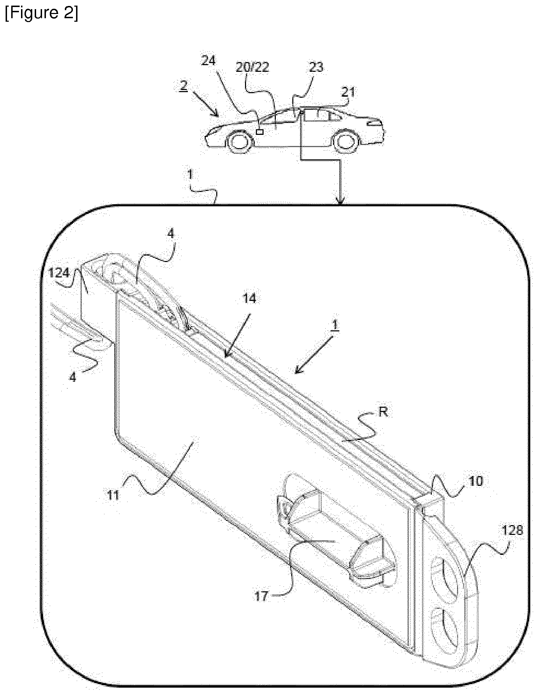

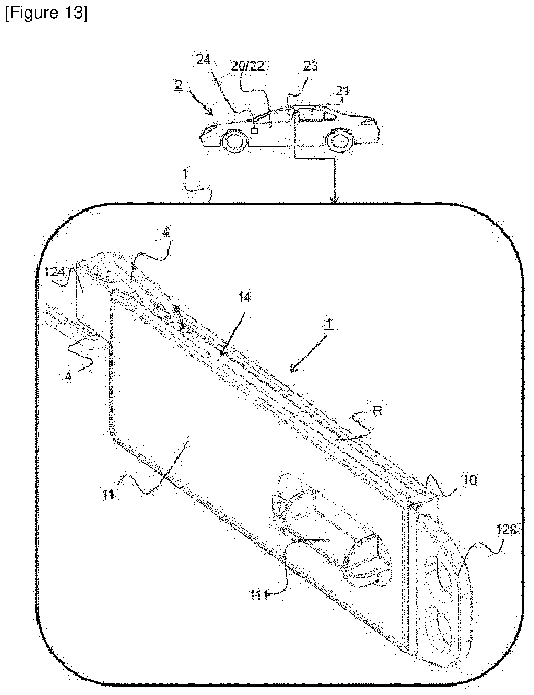

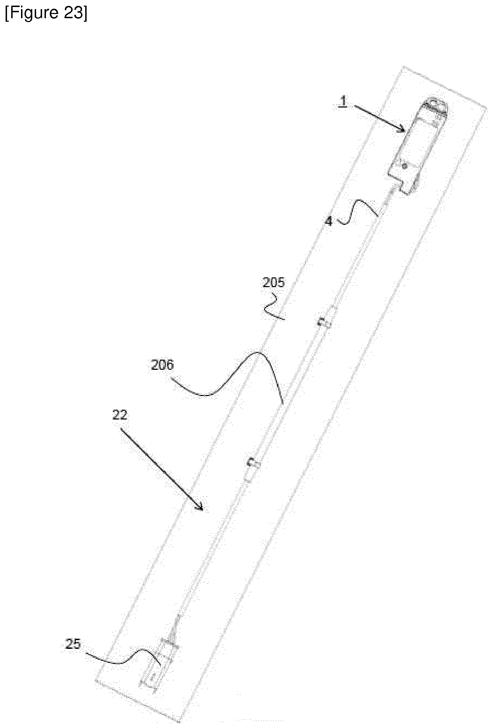

Tel qu'illustré sur les figures 2 et 13, le véhicule automobile 2 comprend :
a. une carrosserie 20,
b. un habitacle 21,
c. une garniture 22 de carrosserie,
d. une unité de contrôle 24,
e. un connecteur 25 (illustré sur la figure 23).

Dans un mode de réalisation non limitatif, la carrosserie 20 est un ouvrant. Dans une variante de réalisation non limitative, l'ouvrant est une portière. Cette variante est prise comme exemple non limitatif dans la suite de la description.

Le boîtier antenne 1 est adapté pour être disposé entre la portière et sa garniture 22, à savoir il se trouve en dessous de la garniture 22 et à l'extérieur de la carrosserie 20. En particulier, dans un mode de réalisation non limitatif, le boîtier antenne 1 est disposé dans le montant de la portière. Le montant est une zone verticale de la portière qui se trouve au niveau de la vitre du véhicule automobile 2. Cela évite à un utilisateur de se baisser lorsqu'il rapproche un identifiant de la portière. C'est ainsi un endroit plus ergonomique car l'utilisateur peut facilement voir un marquage d'identification indiquant l'emplacement où approcher l'identifiant du véhicule automobile 2. L'identifiant est approché ou plaqué contre la portière au niveau du marquage d'identification. Dans un mode de réalisation non limitatif, l'identifiant est un badge, un téléphone intelligent appelé « Smartphone » en anglais, une clef etc. On notera que le montant est une zone non fermée qui n'est donc pas hermétique. Il ne peut être rempli de résine pour étanchéifier le boîtier antenne 1, contrairement à une poignée de portière. Ce n'est ainsi pas une zone étanche.

Dans un mode de réalisation non limitatif, le boîtier antenne 1 assure une fonction d'accès véhicule qui comprend l'identification d'un identifiant de véhicule automobile et le déverrouillage du véhicule automobile. Dans un exemple non limitatif, cette fonction d'accès véhicule est intéressante dans le cas de véhicules électriques partagés.

La carrosserie 20 comprend une face intérieure (non illustrée) dirigée vers l'habitacle 21 du véhicule automobile 20, une face extérieure 205 (illustrée sur la figure 23) dirigée vers l'extérieur du véhicule automobile 20 et une goulotte 206 (illustrée sur la figure 23).

Dans un mode de réalisation non limitatif, le boîtier antenne 1 est disposé de sorte que ladite antenne 12 se trouve en regard de la garniture 22 et ladite platine support secondaire 13 comprenant les composants électroniques 130 se trouve en regard de la portière, à savoir de la carrosserie 20 du véhicule automobile. Plus particulièrement, la platine support secondaire 13 se trouve en regard de la face extérieure 205 de la carrosserie 20. La garniture 22 de la portière 20 appelée également décoration recouvre l'ensemble du boîtier antenne 1 et un faisceau de connexions électriques 4. C'est ainsi une pièce en contrepartie sur la portière 20. Dans un mode de réalisation non limitatif, elle est clippée sur la portière 20. La garniture 22 est légèrement galbée.

Tel qu'illustré sur la figure 23, le faisceau de connexions électriques 4 s'étend le long de la portière 20 à la verticale. La goulotte 206 permet d'accueillir le faisceau de connexions électriques 4. Elle l'oriente bien à la verticale. Le faisceau de connexions électriques 4 s'insère ainsi dans ladite goulotte 206. Il va se connecter au connecteur 25 dudit véhicule automobile 2 adapté pour connecter ledit faisceau de connexions électriques 4 à l'unité de contrôle 24 du véhicule automobile 2. Dans un mode de réalisation non limitatif, le connecteur 25 est adapté pour être disposé sur la portière 20. Dans des variantes de réalisation non limitatives, le connecteur 25 est adapté pour être disposé à l'extérieur de la portière 20, comme le boîtier antenne 1, ou à l'intérieur de la portière 20. Dans un exemple non limitatif, il est disposé en dessous des deux vitres du véhicule automobile 2. Le faisceau de connexions électriques 4 est adapté pour alimenter les composants électroniques 130 de ladite platine support secondaire 13 et pour véhiculer des signaux de commande vers l'unité de contrôle 24 du véhicule automobile 2. A cet effet, il comprend au moins trois fils dont un pour l'alimentation positive, un pour l'alimentation négative, et un pour véhiculer les signaux de commande. Dans un mode de réalisation non limitatif, les signaux de commande sont des signaux LIN (« Local Interconnect Network »). Ce protocole de communication LIN est un protocole de communication économique est couramment utilisé. Dans un autre mode de réalisation non limitatif, les signaux de commande sont des signaux CAN (« Controller Area Network »). Dans ce cas, le faisceau de connexions électriques 4 comprend un fils en plus, le protocole de communication CAN étant un protocole de communication bidirectionnel nécessitant un fil en plus.

Dans un mode de réalisation non limitatif, les signaux de commande comprennent l'autorisation d'accès véhicule sur confirmation d'un identifiant valide et le déverrouillage du véhicule automobile 2, à savoir en particulier de la portière 20. Dans un mode de réalisation, les signaux de commande peuvent en outre comprendre l'identification d'un identifiant du véhicule automobile. Ces signaux de commande sont envoyés si par exemple un utilisateur du véhicule automobile 2 possède le bon identifiant pour accéder au véhicule automobile 2 et a approché son identifiant à une certaine distance d'accès de l'endroit où se trouve le boîtier antenne 1, et en particulier de l'antenne 12 comprise dans ledit boîtier antenne 1. En pratique, l'utilisateur plaquera son identifiant sur le marquage d'identification qui se trouve sur la portière 20 à côté de la vitre et qui définit l'emplacement de l'antenne 12. On notera que la distance d'accès est définie par le type d'antenne 12 utilisé. Dans un mode de réalisation non limitatif, la distance d'accès NFC est de 30mm, plus ou moins 15mm.

Le faisceau de connexions électriques 4 est en outre adapté pour alimenter la platine support primaire 12 lorsqu'un contact électrique est établi entre la platine support secondaire 13 et la platine support primaire 12.

Les éléments du boîtier antenne 1 sont décrits en détail ci-dessous.

Les figures 1 à 11 illustrent le boîtier antenne 1 selon un premier mode de réalisation non limitatif. Les figures 12 à 22 illustrent le boîtier antenne 1 selon un deuxième mode de réalisation non limitatif.

Le boîtier antenne 1 est décrit dans un premier temps selon le premier mode de réalisation non limitatif illustré sur les figures 1 à 11 et 23 ci-après.

La platine support primaire 12 est illustrée sur les figures 1, 3b, 3c, et 5 à 11. Elle forme une antenne. Dans un mode de réalisation non limitatif, l'antenne 12 est une antenne en champ propre NFC « Near Field Communication » en anglais. Ce mode de réalisation est pris comme exemple non limitatif dans la suite de la description. Le protocole de communication NFC utilise une bande de fréquence de 13,56 MHz. La platine support primaire 12 est adaptée pour être disposée dans le réceptacle 10 du boîtier antenne 1.

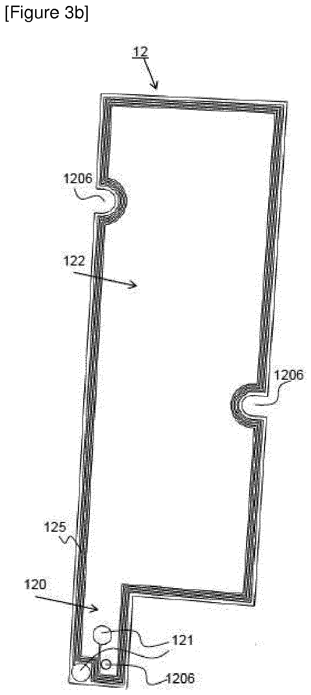

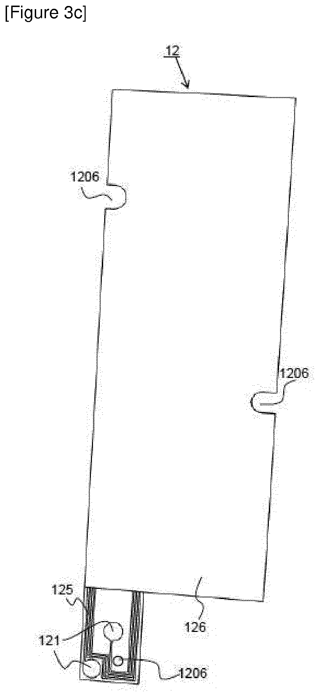

Dans un premier mode de réalisation non limitatif, la platine support primaire 12 est une carte électronique flexible tel que dans un exemple non limitatif un « flexboard ». Dans un deuxième mode de réalisation non limitatif, la platine support primaire 12 est une carte à circuit imprimé telle que dans un exemple non limitatif une carte PCB « Printed Circuit Board » en anglais. Dans un exemple non limitatif, la carte PCB est de type FR4. Dans un mode de réalisation non limitatif, la platine support primaire 12 comprend une hauteur d'environ 0,3mm. Dans un mode de réalisation non limitatif, la platine support primaire 12 est collée sur le réceptacle 10 au moyen d'un adhésif disposé sur sa surface secondaire 123. Tel qu'illustré sur la figure 1, la platine support primaire 12 comprend :
a. un corps avec une surface primaire 122 et une surface secondaire 123 opposée à la surface primaire 122,
b. des pistes sérigraphiées 125 (illustrées sur la figure 3b) en partie sur la surface primaire 122 et en partie sur la zone de contact électrique 120,
c. une ferrite 126 (illustrées sur la figure 3c) qui recouvre lesdites pistes sérigraphiées 125 sur la surface primaire 122,
d. une zone de contact électrique 120 comprenant des zones métallisées 121, appelées « pad » en anglais.

Les pistes sérigraphiées 125 sont en cuivre dans un exemple non limitatif. La surface secondaire 123 est adaptée pour être disposée en regard du réceptacle 10. Ladite surface primaire 122 est adaptée pour être disposée en regard de ladite platine support secondaire 13. La ferrite 126 est donc adaptée pour être disposée en regard de ladite platine support secondaire 13. Dans un mode de réalisation non limitatif, la surface primaire 122 est plane et les pistes sérigraphiées 125 sont disposées sur ladite surface primaire 122 plane. Cela permet d'améliorer les performances de l'antenne 12. La ferrite 126 permet :
a. d'orienter les ondes magnétiques émises par l'antenne 12 dans une direction donnée, ici vers la garniture 22 et donc l'extérieur du véhicule automobile 2,
b. de protéger l'antenne 12 contre le rayonnement électromagnétique, appelé rayonnement CEM, des composants électroniques 130 de la platine support secondaires 13. Elle sert ainsi de bouclier contre le rayonnement CEM.

L'antenne 12 est déportée par rapport à ladite platine support secondaire 13, à savoir elle n'est pas intégrée à ladite platine support secondaire 13. Ainsi, elle est éloignée des composants électroniques 130, ce qui augmente ses performances. Elle est en effet moins impactée par le rayonnement CEM des composants électroniques 130. De plus, l'antenne 12 n'étant pas placée sur la platine support secondaire 13, cela permet une limitation de la surface utilisée par ladite platine support secondaire 13.

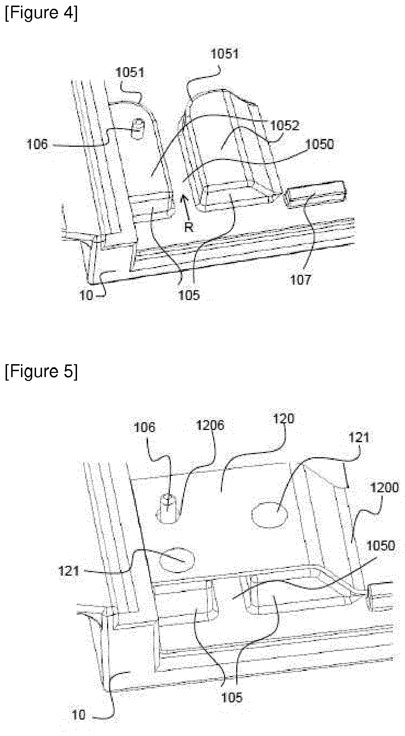

Dans un mode de réalisation non limitatif, la zone de contact électrique 120 est adaptée pour mettre en contact électrique ladite platine support primaire 12 et ladite platine support secondaire 13. Cela permet ainsi d'alimenter la platine support primaire 12 via la platine support secondaire 13, cette dernière étant en contact avec le faisceau de connexions électriques 4. Tel qu'illustré sur les figures 1 et 5, la zone de contact électrique 120 comprend des zones métallisées 121. Dans un mode de réalisation non limitatif, ces zones métallisées 121 sont en cuivre. Dans un mode de réalisation non limitatif, les zones métallisées 121 sont planes. Cela est simple à fabriquer. Dans l'exemple illustré sur les figures, les zones métallisées 121 sont des ronds métallisés. Dans un mode de réalisation non limitatif, la zone de contact électrique 120 comprend deux zones métallisées 121. Une zone métallisée 121 sert de contact électrique positif, et l'autre zone métallisée 121 sert de contact électrique négatif. Les zones métallisées 121 sont en surépaisseur par rapport à la surface de la zone de contact électrique 120. Cela permet de faire correctement le contact électrique. Les zones métallisées 121 sont adaptées pour être disposés en regard des vias 131 (décrits plus loin) de la platine support secondaire 13 décrite plus loin de sorte qu'un contact électrique soit établi via une matière conductrice liquide 3. La matière conductrice liquide 3 en refroidissant permet d'effectuer une soudure entre les zones métallisées 121 et les vias 131.

Dans un mode de réalisation non limitatif illustré sur les figures 1, 5 et 6, la zone de contact électrique 120 est une languette. La languette 120 s'étend en saillie par rapport au corps de la platine support primaire 12. La languette 120 permet de venir en contact avec la platine support secondaire 13 dans une zone non fonctionnelle, tout en laissant un espace entre ladite antenne 12 et les composants électroniques 130 de ladite platine support secondaire 13. Dans un mode de réalisation non limitatif, la languette 120 se situe sur un plan différent de celui du corps de la platine support primaire 12. A cet effet, la languette 120 comporte une pliure 1200. Dans un mode de réalisation non limitatif, elle est adaptée pour reposer sur un bossage 105 du réceptacle 10 décrit plus loin. A cet effet, elle est décalée verticalement par rapport au corps de la platine support primaire 12. Elle se trouve sur un plan décalé par rapport à celui dudit corps. Elle se trouve sur un plan supérieur à celui dudit corps. Dans le cas où la platine support primaire 12 est flexible, elle se plie facilement pour épouser le bossage 105. La languette 120 permet de répondre aux contraintes d'espace imposées par le constructeur automobile et disponibles pour mettre le boîtier antenne 1 sur le véhicule automobile 2. L'espace entre la carrosserie 20 et la garniture 22 est en effet limité. Le fait de venir en contact électrique avec la languette 120 permet de ne pas mettre de connecteur supplémentaire pour connecter la platine support secondaire 13 à l'antenne 12, ou de souder des fils qui prendraient plus d'épaisseur. La connexion se fait dans l'épaisseur de la platine support primaire 12 et de la platine support secondaire 13. La languette 120 est adaptée pour être en contact avec une partie de la platine support secondaire 13 qui comprend les vias 131 (décrits plus loin). Dans un mode de réalisation non limitatif, la languette 120 comprend un orifice de positionnement 1206 illustré sur la figure 5 adapté pour être positionné autour d'un plot de positionnement 106 du réceptacle 10.

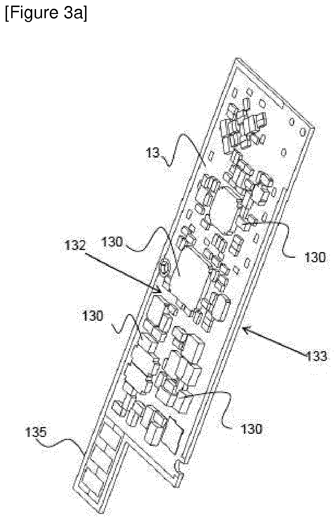

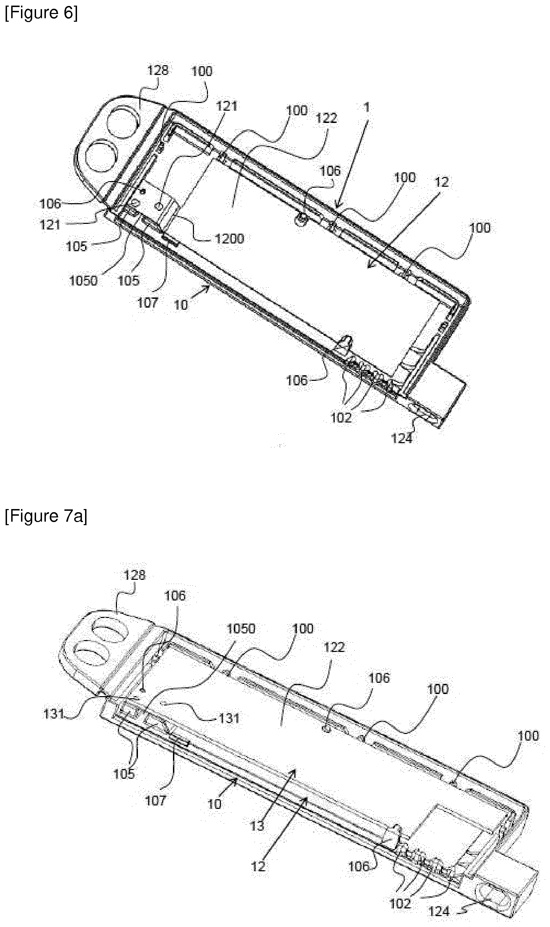

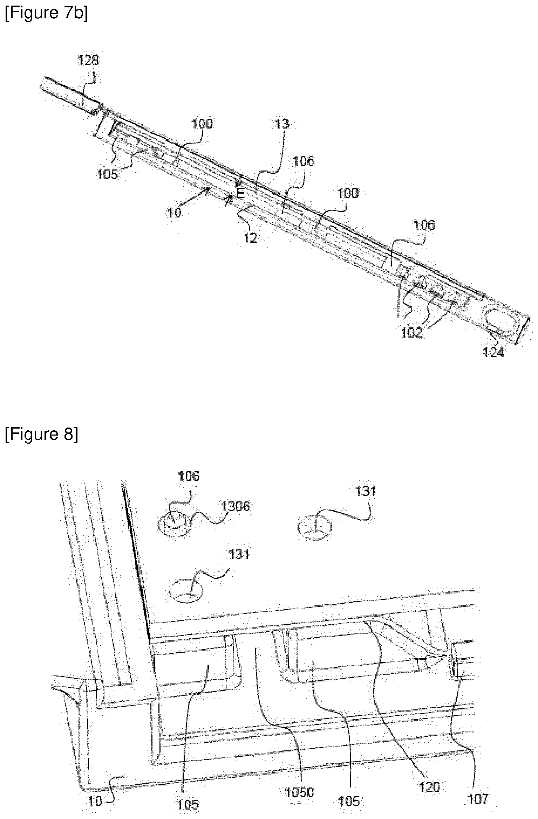

La platine support secondaire 13 est illustrée sur les figures 1, 3, 7a, 7b, et 8 à 11. Tel qu'illustrée sur les figures 1 et 7a et 7b, la platine support secondaire 13 est adaptée pour être disposée dans le réceptacle 10 du boîtier antenne 1 et en regard de la platine support primaire 12. Dans un mode de réalisation non limitatif, la platine secondaire 13 est une carte à circuit imprimé, appelée également PCBA (« Printed Circuit Board Assembly » en anglais). Tel qu'illustré sur les figures 1 et 3a, la platine support secondaire 13 comprend deux faces 132 et 133. Tel qu'illustrée sur la figure 3a, la platine support secondaire 13 comprend des composants électroniques 130 adaptés pour coopérer avec ladite antenne 12. Ces composants électroniques 130 gèrent la communication NFC. Ils sont reliés à l'antenne 12 par les pistes sérigraphiées via le contact électrique établi entre ladite antenne 12 et ladite platine support secondaire 13. Ces composants électroniques 130 permettent notamment d'analyser le signal de l'antenne 12 et de dialoguer avec l'unité de contrôle 24 du véhicule automobile 2. Les composants électroniques 130 sont disposés sur une seule face 132 ou 133 de la platine support secondaire 13 ou sur les deux faces 132 et 133. Dans un mode de réalisation non limitatif, la platine support secondaire 13 avec les composants électroniques 130 comprend une hauteur d'environ 0,8mm.

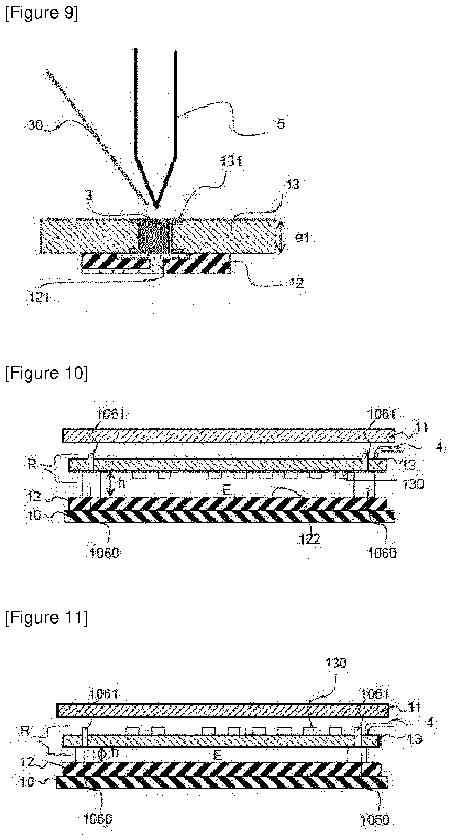

Dans un premier mode de réalisation non limitatif illustré sur la figure 10, les composants électroniques 130 sont disposés sur la platine support secondaire 13 en regard de la platine support primaire 12, à savoir sur la face 133 en regard de la surface primaire 122 de la platine support primaire 12. Dans ce cas, l'espace E entre la platine support primaire 12 et la platine support secondaire 13 est défini de sorte à prendre en compte la hauteur des composants électroniques 130 et l'épaisseur de la résine R à couler entre les deux platines supports primaire 12 et secondaire 13. Dans un mode de réalisation non limitatif, l'espace E comprend une hauteur h environ égale à 2,6mm. On notera que la zone de contact électrique 120 n'est pas représentée sur la figure 10. Dans un deuxième mode de réalisation non limitatif illustré sur les figures 3a et 11, les composants électroniques 130 sont disposés sur la face 132 opposée à la face 133 de la platine support secondaire 13 qui se trouve en regard de la surface primaire 122 de la platine support primaire 12. Dans ce cas, l'espace E entre la platine support primaire 12 et la platine support secondaire 13 est défini de sorte à prendre en compte uniquement l'épaisseur de la résine R à couler entre les deux platines supports primaire 12 et secondaire 13. Dans un mode de réalisation non limitatif, l'espace E comprend une hauteur h environ égale à 1 mm. On notera que la zone de contact électrique 120 n'est pas représentée sur la figure 11.

Tel qu'illustré sur la figure 3a, la platine support secondaire 13 comprend en outre un emplacement 135 sur lequel peuvent être soudés les fils dudit faisceau de connexions électriques 4. Tel qu'illustrée sur la figure 8, la platine support secondaire 13 comprend des vias 131 adaptés pour coopérer avec lesdites zones métallisées 121 de la platine support primaire 12. Les vias 131 sont des trous métallisés. Tel qu'illustré sur la figure 9, les vias 131 sont adaptés pour recevoir une matière conductrice liquide 3 de sorte à faire le contact électrique entre ladite antenne 12 et ladite platine support secondaire 13. Une soudure est ainsi réalisée. Dans un mode de réalisation non limitatif, la matière conductrice liquide 3 est de l'étain. Dans un exemple non limitatif, une baguette d'étain 30 est utilisée et chauffée au moyen d'une buse de chauffage 5. La soudure à l'étain est suffisamment robuste pour résister à la traction liée à la résine R qui se dilate lorsqu'elle est chauffée. Ainsi le contact électrique n'est pas perdu lorsque la résine R chauffe. Dans un autre exemple non limitatif, on peut remplacer la buse de chauffage 5 par un faisceau laser. Lorsque la matière conductrice est chauffée, elle fond, et devient la matière conductrice liquide 3 qui va jusqu'au fond des vias 131 (car liquide) et fait ainsi le contact électrique entre les zones métallisées 121 et les vias 131. De ce fait, la connexion électrique entre la platine support primaire 12 et la platine support secondaire 13 est plus robuste. Comme on peut le voir sur la figure 9, la soudure reste dans l'épaisseur e1 de la platine support secondaire 13. Cela permet de répondre aux contraintes d'espace imposée par le constructeur automobile et disponible pour mettre le boîtier antenne 1 sur le véhicule automobile 2. L'espace entre la carrosserie 20 et la garniture 22 est en effet limité.

Le réceptacle 10 est illustré sur les figures 1, 2 et 4 à 11. Tel qu'illustré sur la figure 1, le réceptacle 10 est adapté pour accueillir la platine support primaire 12 et la platine support secondaire 13. Le réceptacle 10 est adapté pour être assemblé avec le couvercle 11 et permettre le coulage de la résine R par l'ouverture 14 du boîtier antenne 1. A cet effet, il comprend des clips de fixation 100 qui coopèrent avec des clips de fixation (non illustrés) du couvercle 11. De cette manière il est fixé avec le couvercle 11. Dans un mode de réalisation non limitatif, le réceptacle 10 est en outre adapté pour accueillir le faisceau de connexions électriques 4 (illustré sur les figures 2 et 23) pour l'alimentation électrique de la platine support secondaire 13. A cet effet, dans un mode de réalisation non limitatif, il comprend un orifice de passage 124 (illustré sur la figure 2) pour le passage dudit faisceau de connexions électriques 4. Dans un mode de réalisation non limitatif, le réceptacle 10 comprend en en outre au moins une griffe 102 (illustrée sur les figures 6, 7a et 7b) adaptée pour passer le faisceau de connexions électriques 4. Dans l'exemple non limitatif illustré, il comprend quatre griffes 102 qui permettent de pincer trois fils du faisceau de connexions électriques 4. Dans un mode de réalisation non limitatif, le réceptacle 10 comprend en outre un dispositif de fixation 128 sur la carrosserie 20 du véhicule automobile 2. Dans un mode de réalisation non limitatif, le dispositif de fixation 128 est une patte de fixation qui s'étend en saillie par rapport au corps du réceptacle 10. Ladite patte de fixation comprend au moins un orifice. Un rivet peut ainsi être inséré en force dans un orifice de la patte de fixation 128 et passer au travers de la tôle de la portière 20 pour plaquer le boîtier antenne 1 contre ladite portière 20, sur la face extérieure 205 de ladite portière 20.

Tel qu'illustré sur les figures 1 et 2, dans un mode de réalisation non limitatif, le dispositif de fixation 128 comprend deux orifices pour accueillir un rivet (non illustré) dans un exemple non limitatif. Cela permet de s'adapter au montant de portière (droite ou gauche) sur lequel est monté le boîtier antenne 1. On peut ainsi assembler l'antenne 12 dans les deux configurations. Un rivet peut ainsi être inséré en force dans un orifice de la patte de fixation 128 et passer au travers de la tôle de la portière 20 pour plaquer le boîtier antenne 1 contre ladite portière 20, sur la face extérieure 205 de ladite portière 20. Dans un mode de réalisation non limitatif illustré sur la figure 4, le réceptacle 10 comprend en outre une patte de maintien 107 de ladite platine support primaire 12. Elle permet de maintenir en position ladite platine support primaire 12 lorsque cette dernière a été placée dans le réceptacle 10.

Dans un premier mode de réalisation non limitatif illustré sur les figures 1 et 4 à 8, le réceptacle 10 comprend en outre un bossage 105. Dans un mode de réalisation non limitatif, le bossage 105 est en matériau plastique. Tel qu'illustré sur les figures 5 et 6, le bossage 105 est adapté pour recevoir la zone de contact électrique 120 qui est sous forme de languette. La languette 120 avec ses zones métallisées 121 est plaquée sur le bossage 105. A cet effet, le bossage 105 comprend une surface plane 1052 (illustrée sur la figure 4) sur laquelle la languette 120 peut reposer. Dans un mode de réalisation non limitatif, ledit bossage 105 comprend un passage 1050 pour la résine R et l'évacuation de l'air. Cela permet que la résine R s'écoule correctement dans tout le boîtier 1 tel qu'indiqué par la flèche illustré sur la figure 4. On notera que lorsque la résine R est coulée via l'ouverture 14, elle chasse l'air du boîtier antenne 1 qui s'échappe alors par ladite ouverture 14. Le passage 1050 sépare le bossage 105 en deux parties. Dans un mode de réalisation non limitatif illustré sur la figure 4, le bossage 105 comprend en outre au moins un chanfrein 1051. Le bossage 105 étant séparé en deux par le passage 1050, il comprend deux chanfreins 1051 disposés à l'extrémité du passage 1050 formant ainsi deux extrémités. Cela évite la formation de bulles d'air à l'extrémité du passage 1050 lors du coulage de la résine R et permet ainsi d'améliorer l'évacuation de l'air hors du boîtier antenne 1. Le bossage 105 permet de laisser suffisamment de jeu entre la platine support primaire 12 et la platine support secondaire 13 pour que la résine R puisse passer entre les composants électroniques 130 et le support primaire 12.

Le plot de positionnement 106 est illustré sur les figures 1, et 4 à 8, 10 et 11. Dans un mode de réalisation non limitatif, le réceptacle 10 comprend en outre au moins un plot de positionnement 106 de la platine support primaire 12 et de la platine support secondaire 13 dans ledit réceptacle 10. Dans une variante de réalisation non limitative, ledit réceptacle 10 comprend trois plots de positionnement 106. Cela permet de faire un appui plan. Dans un mode de réalisation non limitatif, un plot de positionnement 106 s'étend à partir du bossage 105. Les deux autres plots de positionnement 106 s'étendent directement à partir du fond du réceptacle 10. Tel qu'illustré sur les figures 1, 5 et 6, les plots de positionnement 106 permettent de positionner la platine support primaire 12 dans ledit réceptacle 10. A cet effet, la platine support primaire 12 comprend au moins un orifice de positionnement 1206 adapté pour coopérer avec ledit au moins plot de positionnement 106, trois dans l'exemple non limitatif pris, dans laquelle un plot de positionnement 106 vient s'insérer. Dans un mode de réalisation non limitatif, un des orifices de positionnement 1206 est réalisé dans la languette 120 et les deux autres directement dans le corps de la platine support primaire 12. Ces deux derniers orifices de positionnement 1206 sont ouverts dans l'exemple non limitatif pris et forment ainsi deux encoches tel qu'illustré sur la figure 1.

Tel qu'illustré sur les figures 1, 7a, 7b et 8, les plots de positionnement 106 permettent de positionner la platine support secondaire 13 et donc les composants électroniques 130 dans ledit réceptacle 10. A cet effet, la platine support secondaire 13 comprend au moins un orifice de positionnement 1306 adapté pour coopérer avec ledit au moins plot de positionnement 106, trois dans l'exemple non limitatif pris, dans laquelle un plot de positionnement 106 vient s'insérer. Dans un mode de réalisation non limitatif, un orifice de positionnement 1306 est ouvert dans l'exemple non limitatif pris et forme ainsi une encoche tel qu'illustré sur la figure 1.

Tel qu'illustré sur les figures 1, 10 et 11, au moins un plot de positionnement 106 comprend une base 1060 sur laquelle peut reposer la platine support secondaire 13. Ladite base 1060 est configurée de sorte à avoir un espace E (illustré sur les figures 10 et 11) entre ladite platine support primaire 12 et ladite platine support secondaire 13. Ainsi, la platine support secondaire 13 n'est en contact avec ladite platine support primaire 12 qu'au niveau de la zone de contact électrique 120, à savoir dans l'exemple de la languette, au niveau de la languette. La résine R peut ainsi couler également autour de ces plots de positionnement 106, sauf celui réalisé sur la languette 120. La résine R assure l'étanchéité de l'électronique et permet de ne pas avoir de bulles d'air. Le fait de ne pas avoir de bulles d'air assure de ne pas avoir de corrosion sur l'électronique ou de dilatation trop importante qui pourrait décoller ou casser l'assemblage. Dans un mode de réalisation non limitatif, la base 1060 comprend une hauteur h sensiblement comprise entre 1mm et 3mm. Ainsi, grâce aux plots de positionnement 106, l'antenne 12 est positionnée à une même distance des composants électroniques 130, et donc à une distance répétable d'un boîtier antenne 1 à un autre. On obtient ainsi les mêmes performances d'antenne 12 d'un boîtier antenne 1 à un autre de sorte que la communication NFC fonctionne de manière uniforme d'un véhicule automobile 2 à un autre.

Le couvercle 11 est illustré sur les figures 1, 2, 10 et 11. Il est adapté pour fermer le boîtier antenne 1. A cet effet, il est adapté pour se positionner sur le réceptacle 10. Dans un mode de réalisation non limitatif, il comprend des clips de fixation (non illustrés) adaptés pour coopérer avec les clips de fixation 100 du réceptacle 10. Tel qu'illustré sur la figure 2, dans un mode de réalisation non limitatif, il comprend en outre un dispositif de pré-montage 17 sur la carrosserie 20.

Le dispositif de pré-montage 17 est adapté pour pré-monter le boîtier antenne 1 sur la portière 20 avant son montage définitif, de manière à ce qu'il s'accroche sur ladite portière 20. Il est adapté pour s'insérer dans une fente (non illustrée) de la portière 20 prévue à cet effet. Il est adapté pour translater d'une position initiale à une position finale. Lors de sa position initiale, le boîtier antenne 1 n'est pas encore accroché sur la portière 20. Lors de sa position finale, le boîtier antenne 1 est accroché sur la portière 20. Il ne risque pas de se déplacer ou de tomber si l'opérateur le lâche. Dans une variante de réalisation non limitative, la translation est verticale et s'effectue vers le bas. Cela facilite l'accroche du boîtier antenne 1 sur la portière 20. Dans un mode de réalisation, le dispositif de pré-montage 17 est une patte tel qu'illustré sur la figure 1. Cette patte 17 est adaptée pour passer au travers de la tôle de la portière 20. Le dispositif de pré-montage 17 permet de maintenir en place ledit boîtier antenne 1 et libère ainsi les mains de l'opérateur pour qu'il puisse fixer définitivement le boîtier antenne 1 sur la portière 20, au moyen du dispositif de fixation 128 décrit précédemment.

Le boîtier antenne 1 est maintenant décrit selon le deuxième mode de réalisation non limitatif illustré sur les figures 12 à 22, et 23 ci-après.

La platine support primaire 12 est illustrée sur les figures 12, 14b, 14c, et 16 à 22. La description qui a été faite pour le premier mode de réalisation non limitatif du boîtier antenne 1 s'applique mutatis mutandis au deuxième mode de réalisation non limitatif du boîtier antenne 1. Les figures 1, 3b, 3c, et 5 à 11 sont remplacées respectivement par les figures 12, 14b, 14c, et 16 à 22.

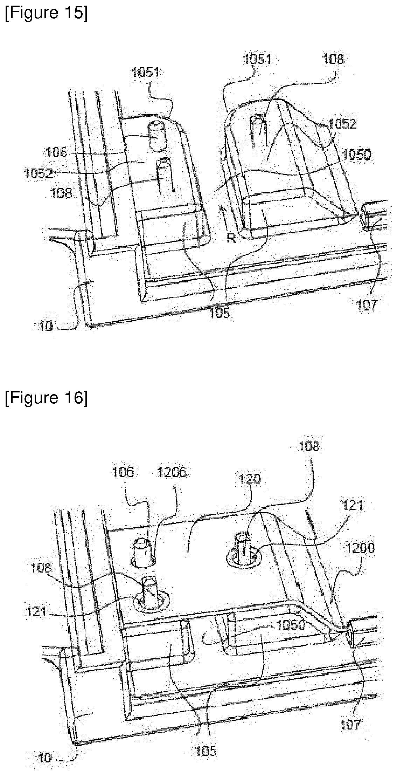

Dans un mode de réalisation non limitatif, la zone de contact électrique 120 est adaptée pour mettre en contact électrique ladite platine support primaire 12 et ladite platine support secondaire 13. Cela permet ainsi d'alimenter la platine support primaire 12 via la platine support secondaire 13, cette dernière étant en contact avec le faisceau de connexions électriques 4.Tel qu'illustré sur les figures 12 et 16, la zone de contact électrique 120 comprend des zones métallisées 121. Dans un mode de réalisation non limitatif, ces zones métallisées 121 sont en cuivre. Dans un mode de réalisation non limitatif, les zones métallisées 121 sont des trous métallisés à travers lesquels des broches métalliques 108 dudit réceptacle 10 peuvent s'insérer. L'orifice de ces trous métallisés 121 est référencé 1210 sur les figures. Dans l'exemple illustré sur les figures, les zones métallisées 121 ont une forme circulaire. Dans un mode de réalisation non limitatif, la zone de contact électrique 120 comprend deux zones métallisées 121. Une zone métallisée 121 sert de contact électrique positif, et l'autre zone métallisée 121 sert de contact électrique négatif. Les zones métallisées 121 sont en surépaisseur par rapport à la surface de la zone de contact électrique 120. Les zones métallisées 121 sont adaptées pour être disposés en regard des vias 131 (décrits plus loin) de la platine support secondaire 13 décrite plus loin de sorte qu'un contact électrique soit établi via une matière conductrice liquide 3. La matière conductrice liquide 3 en refroidissant permet d'effectuer une soudure entre les zones métallisées 121 et les vias 131. En outre, les zones métallisées 121 via leur orifice 1210 sont adaptées pour être positionnées autour des broches métalliques 108 du réceptacle 10 de sorte qu'un contact électrique soit établi entre elles via une matière conductrice liquide 3. La matière conductrice liquide 3 en refroidissant permet d'effectuer une soudure entre les zones métallisées 121 et les broches métalliques 108.

Ainsi, grâce à la matière conductrice liquide 3, on établit un contact électrique entre :
a. les zones métallisées 121 et les vias 131,
b. les zones métallisées 121 et les broches métalliques 108,
c. les vias 131 et les broches métalliques 108.

La matière conductrice liquide 3 fait ainsi le contact électrique entre les zones métallisées 121, les vias 131 et les broches métalliques 108. En réalisant ces différents contacts électriques, cela permet d'établir une connexion électrique entre l'antenne 12 et la platine support secondaire 13.

Dans un mode de réalisation non limitatif illustré sur les figures 12, 16 et 17, la zone de contact électrique 120 est une languette. La languette 120 s'étend en saillie par rapport au corps de la platine support primaire 12. La languette 120 permet de venir en contact avec la platine support secondaire 13 dans une zone non fonctionnelle, tout en laissant un espace entre ladite antenne 12 et les composants électroniques 130 de ladite platine support secondaire 13. Dans un mode de réalisation non limitatif, la languette 120 se situe sur un plan différent de celui du corps de la platine support primaire 12. A cet effet, la languette 120 comporte une pliure 1200. Dans un mode de réalisation non limitatif, elle est adaptée pour reposer sur un bossage 105 du réceptacle 10 décrit plus loin. A cet effet, elle est décalée verticalement par rapport au corps de la platine support primaire 12. Elle se trouve sur un plan décalé par rapport à celui dudit corps. Elle se trouve sur un plan supérieur à celui dudit corps. Dans le cas où la platine support primaire 12 est flexible, elle se plie facilement pour épouser le bossage 105. La languette 120 permet de répondre aux contraintes d'espace imposées par le constructeur automobile et disponibles pour mettre le boîtier antenne 1 sur le véhicule automobile 2. L'espace entre la carrosserie 20 et la garniture 22 est en effet limité. Le fait de venir en contact électrique avec la languette 120 permet de ne pas mettre de connecteur supplémentaire pour connecter la platine support secondaire 13 à l'antenne 12, ou de souder des fils qui prendraient plus d'épaisseur. La connexion se fait dans l'épaisseur de la platine support primaire 12 et de la platine support secondaire 13. La languette 120 est adaptée pour être en contact avec une partie de la platine support secondaire 13 qui comprend les vias 131. Dans un mode de réalisation non limitatif, la languette 120 comprend un orifice de positionnement 1206 illustré sur la figure 16 adapté pour être positionné autour d'un plot de positionnement 106 du réceptacle 10.

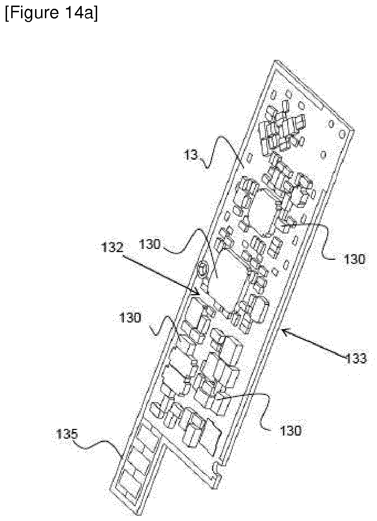

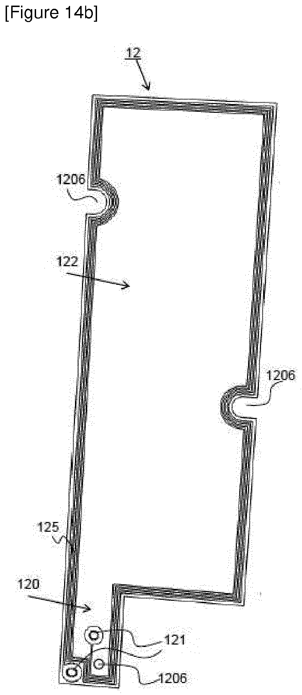

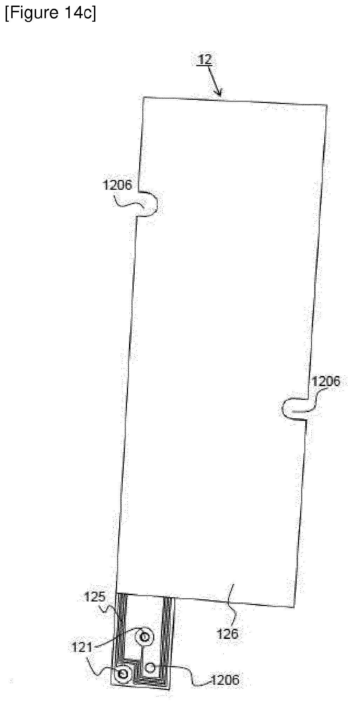

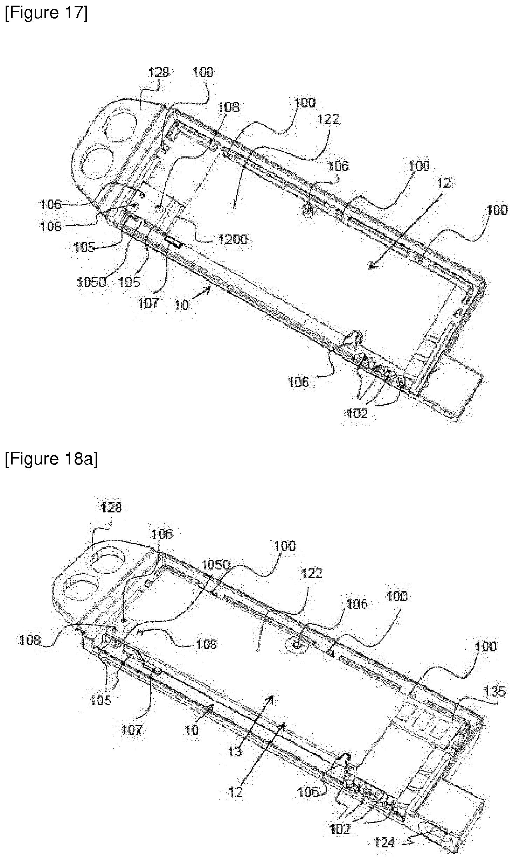

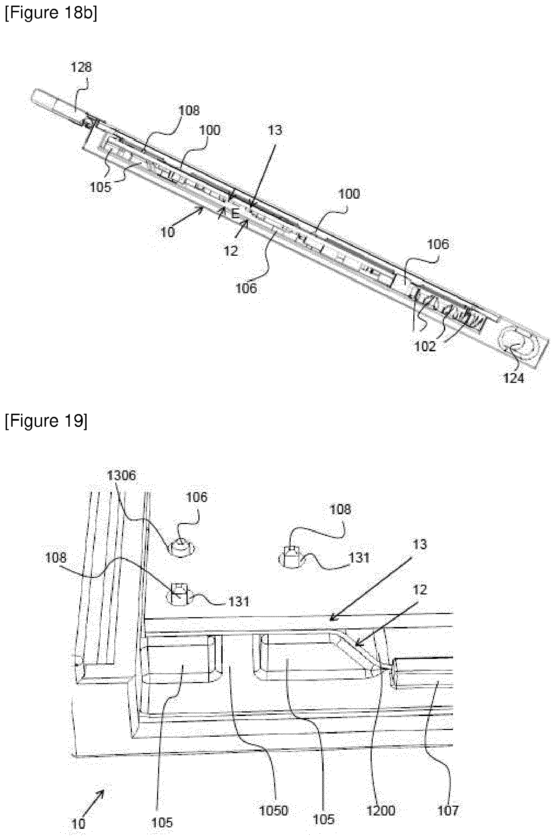

La platine support secondaire 13 est illustrée sur les figures 12, 14a à 14c, 18a, 18b, et 19 à 22. Tel qu'illustrée sur les figures 12 et 18a et 18b, la platine support secondaire 13 est adaptée pour être disposée dans le réceptacle 10 du boîtier antenne 1 et en regard de la platine support primaire 12. Dans un mode de réalisation non limitatif, la platine secondaire 13 est une carte à circuit imprimé, appelée également PCBA (« Printed Circuit Board Assembly » en anglais). Tel qu'illustré sur les figures 12 et 14a, la platine support secondaire 13 comprend deux faces 132 et 133. Tel qu'illustrée sur la figure 14a, la platine support secondaire 13 comprend des composants électroniques 130 adaptés pour coopérer avec ladite antenne 12. Ces composants électroniques 130 gèrent la communication NFC. Ils sont reliés à l'antenne 12 par les pistes sérigraphiées via le contact électrique établi entre ladite antenne 12 et ladite platine support secondaire 13. Ces composants électroniques 130 permettent notamment d'analyser le signal de l'antenne 12 et de dialoguer avec l'unité de contrôle 24 du véhicule automobile 2. Les composants électroniques 130 sont disposés sur une seule face 132 ou 133 de la platine support secondaire 13 ou sur les deux faces 132 et 133. Dans un mode de réalisation non limitatif, la platine support secondaire 13 avec les composants électroniques 130 comprend une hauteur d'environ 0,8mm.

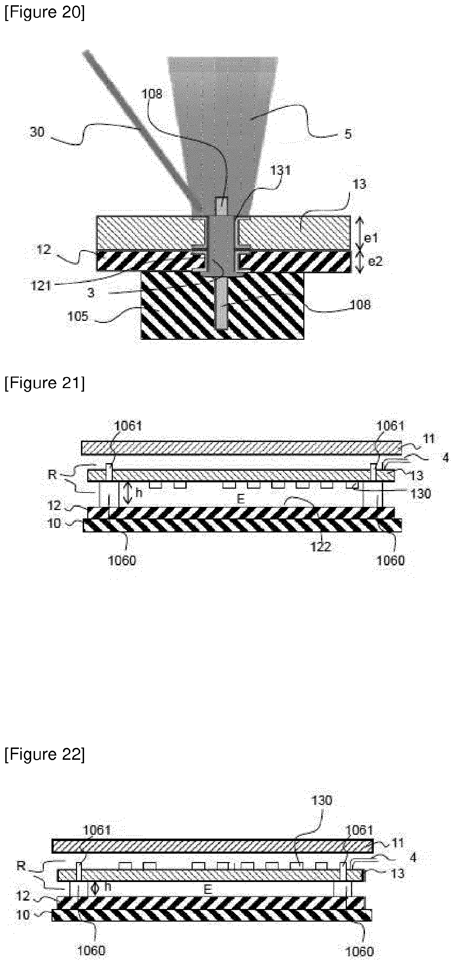

Dans un premier mode de réalisation non limitatif illustré sur la figure 21, les composants électroniques 130 sont disposés sur la platine support secondaire 13 en regard de la platine support primaire 12, à savoir sur la face 133 en regard de la surface primaire 122 de la platine support primaire 12. Dans ce cas, l'espace E entre la platine support primaire 12 et la platine support secondaire 13 est défini de sorte à prendre en compte la hauteur des composants électroniques 130 et l'épaisseur de la résine R à couler entre les deux platines supports primaire 12 et secondaire 13. Dans un mode de réalisation non limitatif, l'espace E comprend une hauteur h environ égale à 2,6mm. On notera que la zone de contact électrique 120 n'est pas représentée sur la figure 21. Dans un deuxième mode de réalisation non limitatif illustré sur les figures 14a et 22, les composants électroniques 130 sont disposés sur la face 132 opposée à la face 133 de la platine support secondaire 13 qui se trouve en regard de la surface primaire 122 de la platine support primaire 12. Dans ce cas, l'espace E entre la platine support primaire 12 et la platine support secondaire 13 est défini de sorte à prendre en compte uniquement l'épaisseur de la résine R à couler entre les deux platines supports primaire 12 et secondaire 13. Dans un mode de réalisation non limitatif, l'espace E comprend une hauteur h environ égale à 1mm. On notera que la zone de contact électrique 120 n'est pas représentée sur la figure 22.

Tel qu'illustré sur la figure 14a, la platine support secondaire 13 comprend en outre un emplacement 135 sur lequel peuvent être soudés les fils dudit faisceau de connexions électriques 4. Tel qu'illustrée sur la figure 19, la platine support secondaire 13 comprend des vias 131 adaptés pour coopérer avec lesdites zones métallisées 121 de la platine support primaire 12 et les broches métalliques 108 dudit réceptacle 10. Les vias 131 sont des trous métallisés. Tel qu'illustré sur la figure 20, les vias 131 sont adaptés pour recevoir une matière conductrice liquide 3 de sorte à faire le contact électrique entre ladite antenne 12 et ladite platine support secondaire 13. Une soudure est ainsi réalisée. Tel qu'illustré sur les figures 19 et 20, les vias 131 sont adaptés pour être positionnés autour des broches métalliques 108 du réceptacle 10 de sorte qu'un contact électrique soit établi entre eux via la matière conductrice liquide 3. La matière conductrice liquide 3 en refroidissant permet d'effectuer une soudure entre les vias 131 et les broches métalliques 108. On notera que la soudure reste ainsi dans l'épaisseur des deux platines supports primaire 12 et secondaire 13.

Dans un mode de réalisation non limitatif, la matière conductrice liquide 3 est de l'étain. Dans un exemple non limitatif, une baguette d'étain 30 est utilisée et chauffée au moyen d'un faisceau laser 5. La soudure à l'étain est suffisamment robuste pour résister à la traction liée à la résine R qui se dilate lorsqu'elle est chauffée. Ainsi le contact électrique n'est pas perdu lorsque la résine R chauffe. Dans un autre exemple non limitatif, on peut remplacer le faisceau laser 5 par une buse de chauffage. Lorsque la matière conductrice est chauffée, elle fond et devient la matière conductrice liquide 3 qui va jusqu'au fond des vias 131 (car liquide) et fait ainsi le contact électrique entre les zones métallisées 121 et les vias 131. Par ailleurs, lorsqu'elle fond, la matière conductrice englobe la partie des broches métalliques 108 qui se trouvent dans les vias 131 et fait ainsi le contact électrique entre les broches métalliques 108 et les vias 131. Enfin, lorsqu'elle fond, la matière conductrice englobe la partie des broches métalliques 108 qui se trouvent dans les zones métallisées 121 et fait ainsi le contact électrique entre les zones métallisées 121 et les broches métalliques 108. De ce fait, la connexion électrique entre la platine support primaire 12 et la platine support secondaire 13 est plus robuste. En effet, les signaux de commande vont pouvoir cheminer des zones métallisées 121 jusqu'aux vias 131 non seulement par l'intermédiaire du contact électrique zones métallisées 121-vias 131 mais également par l'intermédiaire des contacts électriques zones métallisées 121-broches métalliques 108 puis broches métalliques 108-vias 131. Comme on peut le voir sur la figure 20, la soudure reste dans l'épaisseur e1 de la platine support secondaire 13 et dans l'épaisseur e2 de la platine support primaire 12. Cela permet de répondre aux contraintes d'espace imposée par le constructeur automobile et disponible pour mettre le boîtier antenne 1 sur le véhicule automobile 2. L'espace entre la carrosserie 20 et la garniture 22 est en effet limité.

Le réceptacle 10 est illustré sur les figures 12, 13 et 15 à 23. Tel qu'illustré sur la figure 12, le réceptacle 10 est adapté pour accueillir la platine support primaire 12 et la platine support secondaire 13. Le réceptacle 10 est adapté pour être assemblé avec le couvercle 11 et permettre le coulage de la résine R par l'ouverture 14 du boîtier antenne 1. A cet effet, il comprend des clips de fixation 100 qui coopèrent avec des clips de fixation (non illustrés) du couvercle 11. De cette manière il est fixé avec le couvercle 11.

Le réceptacle 10 comprend les broches métalliques 108, également appelées tiges métalliques. Les broches métalliques 108 sont robustes. Dans un mode de réalisation non limitatif, les broches métalliques 108 sont surmoulées dans le réceptacle 10 ou emmanchées dans ledit réceptacle 10. Elles sont adaptées pour coopérer avec les zones métallisées 121 du réceptacle 10 et les vias 131 du couvercle 13. Notamment, elles sont adaptées pour établir un contact électrique entre lesdites zones métallisées 121 et lesdits vias 131 lorsque la matière conductrice liquide 3 coule dans les vias 131 et va jusqu'au fond et se dépose sur lesdites zones métallisées 121 et autour desdites broches métalliques 108. La matière conductrice liquide 3 fait ainsi le contact électrique entre les zones métallisées 121, les vias 131, et les broches métalliques 108. Les broches métalliques 108 permettent de conduire la chaleur pour améliorer la soudure. Elles sont par ailleurs métalliques de sorte qu'elle ne fonde pas lorsque la matière conductrice 5 est chauffée. Elles permettent enfin de renforcer le contact électrique entre les zones métallisées 121 et les vias 131 de sorte que ledit contact électrique ne se rompt pas notamment lors de vibrations du boîtier antenne 1 lorsque le véhicule automobile 2 roule, ou lors de la dilatation de la résine R lors de sa polymérisation. Dans un mode de réalisation non limitatif illustré sur les figures, le réceptacle 10 comprend deux broches métalliques 108. Une broche métallique 108 sert de contact électrique positif, et l'autre broche métallique 108 sert de contact électrique négatif.

Les broches métalliques 108 sont en outre adaptées pour permettre :
a. le positionnement de la zone de contact électrique 120 de la platine support primaire 12 sur le réceptacle 10. Comme illustré sur la figure 16, la partie de la platine support primaire 12 est plaquée contre le réceptacle 10 (ici le bossage 105 décrit plus loin) de sorte que les broches métalliques 108 s'insèrent dans lesdites zones métallisées 121. Lesdites broches métalliques 108 font saillie par rapport à ladite platine support primaire 12 de sorte qu'elles puissent par la suite s'insérer la platine support secondaire 13,
b. le positionnement de la platine support secondaire 13 sur le réceptacle 10. Comme illustré sur la figure 19, la partie de la platine support secondaire 13 est plaquée contre la zone de contact électrique 120 de la platine support primaire 12 (ici la languette) de sorte que les broches métalliques 108 s'insèrent dans lesdits vias 131. Lesdites broches métalliques 108 font saillie par rapport à ladite platine support secondaire 13.

Ainsi, grâce aux broches métalliques 108, il n'est pas nécessaire d'avoir de connecteur supplémentaire pour connecter la platine support secondaire 13 à l'antenne 12, ou de souder des fils qui prendraient plus d'épaisseur. La connexion se fait dans l'épaisseur de la platine support primaire 12 et de la platine support secondaire 13. On obtient ainsi une connexion plus robuste et qui tient les chocs thermiques.

Dans un mode de réalisation non limitatif, le réceptacle 10 est en outre adapté pour accueillir le faisceau de connexions électriques 4 (illustré sur la figure 23) pour l'alimentation électrique de la platine support secondaire 13. A cet effet, dans un mode de réalisation non limitatif, il comprend un orifice de passage 124 (illustré sur la figure 13) pour le passage dudit faisceau de connexions électriques 4. Dans un mode de réalisation non limitatif, le réceptacle 10 comprend en en outre au moins une griffe 102 (illustrée sur les figures 17, 18a et 18b) adaptée pour passer le faisceau de connexions électriques 4. Dans l'exemple non limitatif illustré, il comprend quatre griffes 102 qui permettent de pincer trois fils du faisceau de connexions électriques 4.

Dans un mode de réalisation non limitatif, le réceptacle 10 comprend en outre un dispositif de fixation 128 sur la carrosserie 20 du véhicule automobile 2. Dans un mode de réalisation non limitatif, le dispositif de fixation 128 est une patte de fixation qui s'étend en saillie par rapport au corps du réceptacle 10. Ladite patte de fixation comprend au moins un orifice. Un rivet peut ainsi être inséré en force dans un orifice de la patte de fixation 128 et passer au travers de la tôle de la portière 20 pour plaquer le boîtier antenne 1 contre ladite portière 20, sur la face extérieure 205 de ladite portière 20. Tel qu'illustré sur les figures 12 et 13, dans un mode de réalisation non limitatif, le dispositif de fixation comprend deux orifices pour accueillir un rivet (non illustré) dans un exemple non limitatif. Cela permet de s'adapter au montant de portière (droite ou gauche) sur lequel est monté le boîtier antenne 1. On peut ainsi assembler l'antenne 12 dans les deux configurations. Dans un mode de réalisation non limitatif illustré sur la figure 15, le réceptacle 10 comprend en outre une patte de maintien 107 de ladite platine support primaire 12. Elle permet de maintenir en position ladite platine support primaire 12 lorsque cette dernière a été placée dans le réceptacle 10.

Dans un premier mode de réalisation non limitatif illustré sur les figures 12 et 15 à 19, le réceptacle 10 comprend en outre un bossage 105. Dans un mode de réalisation non limitatif, le bossage 105 est en matériau plastique. Tel qu'illustré sur les figures 16 et 17, le bossage 105 est adapté pour recevoir la zone de contact électrique 120 qui est sous forme de languette. La languette 120 avec ses zones métallisées 121 est plaquée sur le bossage 105. A cet effet, le bossage 105 comprend une surface plane 1052 (illustrée sur la figure 15) sur laquelle la languette 120 peut reposer. Dans un mode de réalisation non limitatif, ledit bossage 105 comprend un passage 1050 pour la résine R et l'évacuation de l'air. Cela permet que la résine R s'écoule correctement dans tout le boîtier 1 tel qu'indiqué par la flèche illustré sur la figure 15. On notera que lorsque la résine R est coulée via l'ouverture 14, elle chasse l'air du boîtier antenne 1 qui s'échappe alors par ladite ouverture 14. Le passage 1050 sépare le bossage en deux parties.

Dans un mode de réalisation non limitatif illustré sur la figure 15, le bossage 105 comprend en outre au moins un chanfrein 1051. Le bossage 105 étant séparé en deux par le passage 1050, il comprend deux chanfreins 1051 disposés à l'extrémité du passage 1050 formant ainsi deux extrémités. Cela évite la formation de bulles d'air à l'extrémité du passage 1050 lors du coulage de la résine R et permet ainsi d'améliorer l'évacuation de l'air hors du boîtier antenne 1. Le bossage 105 permet de laisser suffisamment de jeu entre la platine support primaire 12 et la platine support secondaire 13 pour que la résine R puisse passer entre les composants électroniques 130 et le support primaire 12. Dans ce mode de réalisation avec bossage 105, ledit bossage 105 comprend les broches métalliques 108. Elles sont ainsi intégrées dans ledit bossage 105. Dans un exemple non limitatif, elles sont surmoulées avec ledit bossage 105 ou emmanchées dans ledit bossage 105. Cela évite que les broches métalliques 108 ne bougent pendant l'assemblage de l'ensemble des éléments du boîtier antenne 1. On notera qu'il y a suffisamment d'épaisseur pour que les broches métalliques 108 soient maintenues dans le bossage 105. Le bossage 105 permet ainsi de maîtriser la position des broches métalliques 108 et leur tenue. Ainsi, on a une position précise. Il n'y a pas de risque que les broches métalliques 108 bougent pendant l'assemblage des éléments du boîtier antenne 1 ou lors de la manipulation du boîtier antenne 1 lors de son montage sur le véhicule automobile 2. On a ainsi une position répétable des broches métalliques 108 d'un boîtier antenne à un autre boîtier antenne sur la chaîne d'assemblage.

Le plot de positionnement 106 est illustré sur les figures 12, et 15 à 19, 21 et 22. La description qui a été faite pour le premier mode de réalisation non limitatif du boîtier antenne 1 s'applique mutatis mutandis au deuxième mode de réalisation non limitatif du boîtier antenne 1. Les figures 1, et 4 à 8, 10 et 11 sont remplacées respectivement par les figures 12, et 15 à 19, 21 et 22.

Le couvercle 11 est illustré sur les figures 12, 13, 21 et 22. La description qui a été faite pour le premier mode de réalisation non limitatif du boîtier antenne 1 s'applique mutatis mutandis au deuxième mode de réalisation non limitatif du boîtier antenne 1. Les figures 1, 2, 10 et 11 sont remplacées respectivement par les figures 12, 13, 21 et 22.

Bien entendu la description de l'invention n'est pas limitée à l'application, aux modes de réalisation et aux exemples décrits ci-dessus. Ainsi, dans un autre mode de réalisation non limitatif, le réceptacle 10 ne comprend pas de bossage 105. Dans ce cas, dans une première variante de réalisation non limitative, la zone de contact électrique 120 de la platine support primaire 12 se trouve sur le même plan que le corps de la platine support primaire 12. Elle se trouve ainsi dans la continuité dudit corps. Elle repose sur un plot de positionnement 106 qui s'étend directement à partir du fond du réceptacle 10. Dans une deuxième variante de réalisation non limitative, la zone de contact électrique 120 de la platine support primaire 12 se trouve sur un plan décalé par rapport à celui du corps de la platine support primaire 12. Elle se trouve sur un plan inférieur à celui dudit corps.

Ainsi, l'invention décrite présente notamment les avantages suivants :
a. elle permet de réaliser un contact électrique entre la platine support primaire 12 et la platine support secondaire 13 dans une zone résinée,
b. elle permet de réduire l'épaisseur du boîtier antenne 1, la soudure ne dépassant pas de l'épaisseur de la platine support secondaire 13 contrairement à l'utilisation d'une patte ressort comme dans l'état de la technique antérieur ou l'utilisation de connecteurs mâle et femelle entre l'antenne 12 et la platine support secondaire 13. Il n'y a pas de ménisque de soudure qui pourrait se rajouter à l'épaisseur de la platine support secondaire 13,
c. elle permet d'éviter une épaisseur de soudure en plus, contrairement à un état de la technique antérieur dans lequel un fil soudé est utilisé entre l'antenne 12 et la platine support secondaire 13,
d. elle permet d'avoir un positionnement répétable de l'antenne 12 par rapport à la platine support secondaire 13 qui supporte l'électronique, à savoir les composants électroniques 130. Les performances de l'antenne 12 sont ainsi uniformes d'un boîtier antenne 1 à un autre, contrairement à l'état de la technique antérieur avec une patte ressort ou un fil soudé dans lequel la position de ladite patte ressort ou dudit fil soudé est difficile à maîtriser,
e. elle évite une perte de contact électrique entre l'antenne 12 et les composants électroniques 130 lors de la polymérisation de la résine R, puisque lorsque la résine R se dilate, la soudure effectuée entre les zones métalliques 121 et les vias 131 demeure intacte et permet toujours d'assurer un bon contact électrique. La soudure est en effet plus robuste que l'effort appliqué par la dilatation de la résine R, à de hautes températures telle qu'une température de 85 degrés Celsius classiquement spécifiée dans le domaine des véhicules automobiles,
f. elle permet d'avoir un boîtier antenne 1 robuste et étanche grâce à la résine R qui entoure les deux platines supports primaire 12 et secondaire 13, et qui coule correctement dans ledit boîtier antenne 1, ce qui est nécessaire au vu du placement du boîtier antenne 1 à l'extérieur de la carrosserie 20. Cette position n'est en effet pas étanche puisque de l'eau peut s'infiltrer entre la garniture 22 et la carrosserie 20,
g. elle permet d'avoir un contact électrique robuste contrairement à un état de la technique antérieur qui réalise un contact électrique avec un contact ressort (à l'aide d'une lame métallique) dans une résine. En effet, dans le cas de l'état de la technique antérieur, lorsque la résine chauffe, elle se dilate et le contact électrique est rompu avec ladite lame métallique,
h. elle permet d'augmenter les performances de l'antenne 12 car ladite antenne 12 est déportée de l'électronique (à savoir des composants électroniques 130) puisque différente de la platine support secondaire 13 qui supporte l'électronique. L'antenne 12 est ainsi moins impactée par le rayonnement CEM des composants électroniques 130, contrairement à un état de la technique antérieur dans lequel l'antenne est placée sur la même platine support que l'électronique et entoure lesdits composants électroniques,
i. elle permet grâce aux zones métalliques 121 et aux vias 131 d'avoir un contact électrique entre l'antenne 12 et la platine support secondaire 13 qui prend peu de surface sur ladite platine support secondaire 13 ce qui permet d'avoir de laisser plus de surface pour les composants électroniques 130 ou de réduire la surface de ladite platine support secondaire 13,
j. elle permet un contact électrique sans composant supplémentaire (tel qu'un fil soudé, un connecteur, une patte ressort etc.),
k. elle permet d'effectuer une connexion électrique entre l'antenne 12 et la platine support secondaire 13 grâce aux broches métalliques 108 intégrées dans le réceptacle 10 et aux vias 131 et aux zones métallisées 121,
l. elle présente une solution meilleure et alternative à une solution qui utiliserait de la pâte à braser pour faire un contact électrique entre l'antenne 12 et la platine support secondaire 13, car elle n'utilise pas d'étape de refusion qui dégrade l'antenne 12 comme dans la solution avec la pâte à braser, la température pour faire fondre la patte à braser étant trop grande pour l'antenne 12 lorsque cette dernière est flexible.

## Revendications

1. Boîtier antenne (1) pour véhicule automobile (2), selon lequel ledit boîtier antenne (1) comprend :
- une platine support primaire (12),
- une platine support secondaire (13),
- un réceptacle (10) adapté pour accueillir la platine support primaire (12) et la platine support secondaire (13) ;
- un couvercle (11) adapté pour fermer ledit boîtier antenne (1) de sorte à laisser une ouverture (14) pour couler une résine (R) dans ledit boîtier antenne (1) ;
- ladite platine support primaire (12) formant une antenne et une zone de contact électrique (120) avec ladite platine support secondaire (13), ladite zone de contact électrique (120) comprenant des zones métallisées (121) ; et
- ladite platine support secondaire (13) étant disposée en regard de ladite platine support primaire (12) et comprenant des composants électroniques (130) adaptés pour coopérer avec ladite antenne (12), **caractérisé en ce que** ladite platine support secondaire (13) comprend des vias (131) coopérant avec lesdites zones métallisées (121) de ladite antenne (12) et recevant une matière conductrice liquide (3) de sorte à faire un contact électrique entre ladite antenne (12) et ladite platine support secondaire (13) ; ladite zone de contact électrique (120) est une languette, ledit réceptacle (10) comprenant un bossage (105) adapté pour recevoir la zone de contact électrique 120, ledit bossage (105) comprenant un passage (1050) pour ladite résine (R) et pour l'évacuation d'air.

2. Boîtier antenne (1) selon la revendication 1, selon lequel lesdites zones métallisées (121) sont planes.

3. Boîtier antenne (1) selon la revendication 1 ou la revendication 2, selon lequel ladite matière conductrice liquide (3) est de l'étain.

4. Boîtier antenne (1) selon l'une quelconque des revendications précédentes 1 à 3, selon lequel ladite zone de contact électrique (120) comprend deux zones métallisées (121).

5. Boîtier antenne (1) selon l'une quelconque des revendications précédentes 1 à 4, selon lequel ledit bossage (105) comprend en outre au moins un chanfrein (1051).

6. Boîtier antenne (1) selon l'une quelconque des revendications précédentes 1 à 5, selon lequel ledit réceptacle (10) comprend en outre au moins un plot de positionnement (106) de ladite platine support primaire (12) et de ladite platine support secondaire (13) dans ledit réceptacle (10).

7. Boîtier antenne (1) selon la revendication 6, selon lequel ledit réceptacle (10) comprend trois plots de positionnement (106).

8. Boîtier antenne (1) selon l'une quelconque des revendications précédentes 6 ou 7, selon lequel ledit au moins plot de positionnement (106) comprend une base (1060) sur laquelle peut reposer ladite platine support secondaire (13), ladite base (1060) étant configurée de sorte à avoir un espace (E) entre ladite platine support primaire (12) et ladite platine support secondaire (13).

9. Boîtier antenne (1) selon la revendication 8, selon lequel ladite base (1060) comprend une hauteur (h) sensiblement comprise entre 1mm et 3mm.

10. Boîtier antenne (1) selon l'une quelconque des revendications précédentes 1 à 9, selon lequel ladite platine support primaire (12) comprend des pistes sérigraphiées (125) et une ferrite (126) adaptée pour être disposée en regard de ladite platine support secondaire (13).

11. Boîtier antenne (1) selon l'une quelconque des revendications précédentes 1 à 10, selon lequel ladite platine support primaire (12) est une carte électronique flexible ou une carte à circuit imprimé (PCB).

12. Boîtier antenne (1) selon l'une quelconque des revendications précédentes 1 à 11, selon lequel ladite antenne (12) est une antenne en champ proche (NFC).

## Patentansprüche

1. Antennengehäuse (1) für ein Kraftfahrzeug (2), wobei das Antennengehäuse (1) enthält:
- eine primäre Trägerplatte (12),
- eine sekundäre Trägerplatte (13),
- einen Behälter (10), der geeignet ist, die primäre Trägerplatte (12) und die sekundäre Trägerplatte (13) aufzunehmen;
- einen Deckel (11), der geeignet ist, das Antennengehäuse (1) derart zu schließen, dass eine Öffnung (14) freigelassen wird, um ein Harz (R) in das Antennengehäuse (1) zu gießen;
- wobei die primäre Trägerplatte (12) eine Antenne und eine elektrische Kontaktzone (120) mit der sekundären Trägerplatte (13) bildet, wobei die elektrische Kontaktzone (120) metallbeschichtete Zonen (121) enthält; und
- wobei die sekundäre Trägerplatte (13) gegenüber der primären Trägerplatte (12) angeordnet ist und elektronische Bauteile (130) enthält, die geeignet sind, mit der Antenne (12) zusammenzuwirken,
**dadurch gekennzeichnet, dass** die sekundäre Trägerplatte (13) Lücken (131) enthält, die mit den metallbeschichteten Zonen (121) der Antenne (12) zusammenwirken und ein flüssiges leitendes Material (3) empfangen, um einen elektrischen Kontakt zwischen der Antenne (12) und der sekundären Trägerplatte (13) herzustellen;
die elektrische Kontaktzone (120) eine Zunge ist, wobei der Behälter (10) eine Wölbung (105) enthält, die geeignet ist, die elektrische Kontaktzone (120) aufzunehmen, wobei die Wölbung (105) einen Durchgang (1050) für das Harz (R) und zur Entlüftung enthält.

2. Antennengehäuse (1) nach Anspruch 1, wobei die metallbeschichteten Zonen (121) eben sind.

3. Antennengehäuse (1) nach Anspruch 1 oder Anspruch 2, wobei das flüssige leitende Material (3) Zinn ist.

4. Antennengehäuse (1) nach einem der vorhergehenden Ansprüche 1 bis 3, wobei die elektrische Kontaktzone (120) zwei metallbeschichtete Zonen (121) enthält.

5. Antennengehäuse (1) nach einem der vorhergehenden Ansprüche 1 bis 4, wobei die Wölbung (105) außerdem mindestens eine Abfasung (1051) enthält.

6. Antennengehäuse (1) nach einem der vorhergehenden Ansprüche 1 bis 5, wobei der Behälter (10) außerdem mindestens einen Positionierklotz (106) der primären Trägerplatte (12) und der sekundären Trägerplatte (13) im Behälter (10) enthält.

7. Antennengehäuse (1) nach Anspruch 6, wobei der Behälter (10) drei Positionierklötze (106) enthält.

8. Antennengehäuse (1) nach einem der vorhergehenden Ansprüche 6 oder 7, wobei der mindestens eine Positionierklotz (106) eine Basis (1060) enthält, auf der die sekundäre Trägerplatte (13) ruhen kann, wobei die Basis (1060) so konfiguriert ist, dass es einen Raum (E) zwischen der primären Trägerplatte (12) und der sekundären Trägerplatte (13) gibt.

9. Antennengehäuse (1) nach Anspruch 8, wobei die Basis (1060) eine Höhe (h) enthält, die im Wesentlichen zwischen 1mm und 3mm liegt.

10. Antennengehäuse (1) nach einem der vorhergehenden Ansprüche 1 bis 9, wobei die primäre Trägerplatte (12) Siebdruckbahnen (125) und einen Ferrit (126) enthält, der geeignet ist, gegenüber der sekundären Trägerplatte (13) angeordnet zu werden.

11. Antennengehäuse (1) nach einem der vorhergehenden Ansprüche 1 bis 10, wobei die primäre Trägerplatte (12) eine biegsame Elektronikkarte oder eine Leiterplatte (PCB) ist.

12. Antennengehäuse (1) nach einem der vorhergehenden Ansprüche 1 bis 11, wobei die Antenne (12) eine Nahfeld-Antenne (NFC) ist.

## Claims

1. Antenna housing (1) for a motor vehicle (2), wherein said antenna housing (1) comprises:
- a primary support plate (12),
- a secondary support plate (13),
- a receptacle (10) suitable for accommodating the primary support plate (12) and the secondary support plate (13);
- a cover (11) suitable for closing said antenna housing (1) so as to leave an opening (14) for pouring a resin (R) into said antenna housing (1);
- said primary support plate (12) forming an antenna and an electrical contact zone (120) for electrical contact with said secondary support plate (13), said electrical contact zone (120) comprising metallized zones (121); and
- said secondary support plate (13) being arranged facing said primary support plate (12) and comprising electronic components (130) suitable for cooperating with said antenna (12), **characterized in that** said secondary support plate (13) comprises vias (131) cooperating with said metallized zones (121) of said antenna (12) and receiving a liquid conductive material (3) so as to establish electrical contact between said antenna (12) and said secondary support plate (13);
said electrical contact zone (120) is a tab, said receptacle (10) comprising a boss (105) suitable for receiving the electrical contact zone (120), said boss (105) comprising a passage (1050) for said resin (R) and for discharging air.

2. Antenna housing (1) according to Claim 1, wherein said metallized zones (121) are planar.

3. Antenna housing (1) according to Claim 1 or Claim 2, wherein said liquid conductive material (3) is tin.

4. Antenna housing (1) according to any one of the preceding Claims 1 to 3, wherein said electrical contact zone (120) comprises two metallized zones (121).

5. Antenna housing (1) according to any one of the preceding Claims 1 to 4, wherein said boss (105) also comprises at least one chamfer (1051).

6. Antenna housing (1) according to any one of the preceding Claims 1 to 5, wherein said receptacle (10) also comprises at least one positioning stud (106) for positioning said primary support plate (12) and said secondary support plate (13) in said receptacle (10).

7. Antenna housing (1) according to Claim 6, wherein said receptacle (10) comprises three positioning studs (106) .

8. Antenna housing (1) according to either one of the preceding Claims 6 and 7, wherein said at least one positioning stud (106) comprises a base (1060) on which said secondary support plate (13) can rest, said base (1060) being configured so as to have a space (E) between said primary support plate (12) and said secondary support plate (13).

9. Antenna housing (1) according to Claim 8, wherein said base (1060) comprises a height (h) that is substantially between 1 mm and 3 mm.

10. Antenna housing (1) according to any one of the preceding Claims 1 to 9, wherein said primary support plate (12) comprises screen-printed tracks (125) and a ferrite (126) that is suitable for being arranged facing said secondary support plate (13).

11. Antenna housing (1) according to any one of the preceding Claims 1 to 10, wherein said primary support plate (12) is a flexible circuit board or a printed circuit board (PCB).

12. Antenna housing (1) according to any one of the preceding Claims 1 to 11, wherein said antenna (12) is a near-field (NFC) antenna.
